# FASCICULE DE BREVET EUROPEEN

(11) **EP 3 399 612 B1**
(45) Date de publication et mention de la délivrance du brevet: **09.06.2021**
(21) Numéro de dépôt: 18169412.6
(22) Date de dépôt: 26.04.2018
(51) Int. Cl.: H02H 1/00, H02H 3/17, H02H 7/22, G01R 31/12

(54) **LIAISON ÉLECTRIQUE COMPRENANT UN DISPOSITIF DE PROTECTION ÉLECTRIQUE - POLARISATION EN COURANT**
ELEKTRISCHER ANSCHLUSS, DER EINE ELEKTRISCHE SCHUTZVORRICHTUNG ZUR STROMVORSPANNUNG UMFASST
ELECTRICAL CONNECTION COMPRISING AN ELECTRICAL PROTECTION - CURRENT BIAS DEVICE

(30) Priorité: 03.05.2017 FR 1753860
(43) Date de publication de la demande: 07.11.2018
(73) Titulaire: Airbus Operations S.A.S., 31060 Toulouse (FR)
(72) Inventeur: OMS, Patrick, 31770 COLOMIERS (FR)
(74) Mandataire: Gicquel, Olivier Yves Gérard

(56) Documents cités:
- DE-A1-102012 019 996
- JP-A- 2002 247 753
- US-A- 6 084 207
- US-A1- 2003 002 235
- US-A1- 2005 128 661

## Description

La présente invention concerne une liaison électrique pour la transmission d'une haute tension à courant continu à un équipement utilisateur, ladite liaison comprenant un dispositif de protection électrique pour fournir l'énergie électrique de manière sécurisée. L'invention concerne également un procédé de fourniture sécurisée d'énergie électrique à un équipement utilisateur d'un véhicule via une liaison électrique.

Une installation électrique d'un aéronef comprend une source d'alimentation électrique reliée à un équipement utilisateur à alimenter en énergie électrique via une liaison électrique formée d'un conducteur électrique recouvert d'une enveloppe isolante. La liaison électrique comprend un dispositif de type disjoncteur pour surveiller les paramètres du signal électrique transitant via la liaison entre la source d'alimentation et l'équipement utilisateur afin d'interrompre un courant de surcharge ou un courant de court-circuit dans le conducteur.

On connait dans d'autres domaines tels que l'automobile, et tel que décrit dans la demande US 2005/128661, un dispositif électrique de protection adapté à des installations électriques basse tension (de l'ordre de 42 Volts) qui permet de détecter des arcs électriques au niveau du conducteur reliant la source d'alimentation à un équipement utilisateur. Le dispositif de protection comprend une gaine conductrice entourant le conducteur tout en étant isolée de ce dernier, ainsi qu'une partie électrique chargée de détecter les fluctuations de courant dans la gaine conductrice. Lorsque le courant dans la gaine conductrice a une valeur dépassant une valeur seuil proche de zéro, le dispositif électronique déclenche le disjoncteur afin d'interrompre le courant de surcharge ou de courant de court-circuit dans le conducteur.

Il est également connu du document DE102012019996, un dispositif électrique de protection adapté à des installations électriques pour des tensions de quelques centaines de Volts et qui permet de détecter des arcs électriques au niveau du conducteur reliant la source d'alimentation à un équipement utilisateur. Le dispositif de protection comprend une gaine conductrice entourant le conducteur tout en étant isolée de ce dernier, ainsi qu'un dispositif électronique chargé de détecter les fluctuations de tension aux bornes d'une résistance reliant la gaine conductrice à un potentiel de référence. Lorsque la tension a une valeur dépassant une valeur seuil, le dispositif électronique déclenche le disjoncteur afin d'interrompre le courant de surcharge ou de courant de court-circuit dans le conducteur.

La puissance électrique consommée dans les aéronefs est en constante augmentation. Cette évolution conduit inévitablement à une élévation des niveaux de tension des systèmes d'alimentation électrique dans les aéronefs qui étaient classiquement de 115 AC (AC pour alternative current : courant alternatif) et 28 Volts DC (DC pour direct current : courant continu).

Des tensions de l'ordre de +/- 270 Volts DC ou 540Volts DC sont aujourd'hui considérées.

De telles valeurs de tensions font apparaître de nouvelles problématiques dans les aéronefs. Par exemple, des arcs électriques séries ou parallèles peuvent apparaître lors d'une fuite de courant hors de la liaison électrique. Un arc parallèle entre un conducteur électrique alimentant un équipement et la structure conductrice d'un aéronef, ou entre deux conducteurs électriques adjacents pourraient endommager l'équipement utilisateur.

Les dispositifs de type disjoncteurs de l'art antérieur ne sont pas optimisés pour sécuriser la transmission d'énergie via les liaisons électriques d'installations utilisant de telles tensions. En effet, à de telles tensions, avec les disjoncteurs de l'art antérieur, il est obligatoire de respecter de fortes distances de sécurités entre un toron comportant des câbles d'alimentation et le châssis de l'aéronef, ou entre un toron comportant des câbles d'alimentation et un autre toron comportant des câbles de transmission de données, pour éviter qu'un éventuel arc électrique dans le toron comportant des câbles d'alimentation n'endommage par effet thermique la structure conductrice de l'aéronef, ou le toron comportant des câbles de transmission de données. Ces obligations de sécurités génèrent de fortes contraintes d'espace dans un aéronef.

Il existe un besoin de trouver un dispositif de protection électrique d'une liaison électrique permettant de sécuriser la fourniture en énergie électrique à haute tension à un équipement utilisateur d'un véhicule, surmontant tout ou en partie l'inconvénient de l'art antérieur susmentionné. A cet effet, telle que revendiquée dans la revendication 1, l'invention concerne une liaison électrique comprenant un dispositif de protection électrique adaptée à relier une source d'alimentation haute tension à courant continu à un équipement utilisateur.

L'invention concerne également, selon la revendication 6, un procédé de fourniture sécurisée d'énergie électrique à un équipement utilisateur d'un véhicule via la liaison électrique de la revendication 1.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
- la figure 1 représente un aéronef comportant une installation électrique ayant une source d'alimentation connectée à un équipement utilisateur via une liaison électrique et une ligne de retour de courant, et un dispositif de protection électrique de la liaison électrique selon un mode de réalisation de l'invention ;
- la figure 2 représente un schéma bloc de l'installation électrique représentée à la figure 1, et une représentation du dispositif de protection électrique de la liaison électrique selon un mode de réalisation de l'invention ;
- la figure 3 représente une vue schématique d'une gaine conductrice arrangée sur une liaison électrique et formant une partie du dispositif de protection électrique selon l'invention;
- la figure 4 représente un schéma électrique de l'installation électrique représentée à la figure 2;
- la figure 5 est un diagramme illustrant l'évolution du courant mesuré à un point de prélèvement d'une gaine conductrice selon la figure 3 lorsque cette dernière est polarisée en courant ;
- la figure 6 est une vue similaire à la figure 2 dans laquelle le dispositif de protection électrique du conducteur comprend en outre un module de test selon un mode de réalisation de l'invention ; et
- la figure 7 représente un schéma électrique de l'installation électrique représentée à la figure 6.

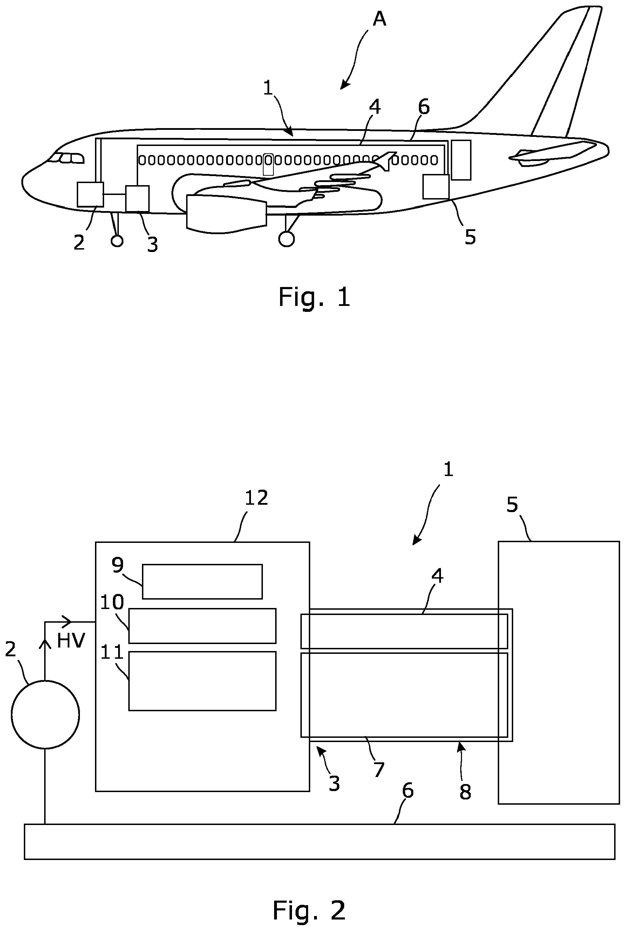

En relation avec la figure 1, un aéronef A comporte une installation électrique 1 ayant une source d'alimentation 2 en haute tension connectée à un équipement utilisateur 5 via une liaison électrique 8 comprenant un dispositif de protection électrique 3 associée à la liaison électrique 8.

La source d'alimentation 2 est en outre reliée à l'équipement utilisateur 5 par une ligne de retour de courant 6.

La source d'alimentation 2 en haute tension fournit une tension HV continue de l'ordre de + ou - 270 Volts DC, ou encore de 540Volts DC.

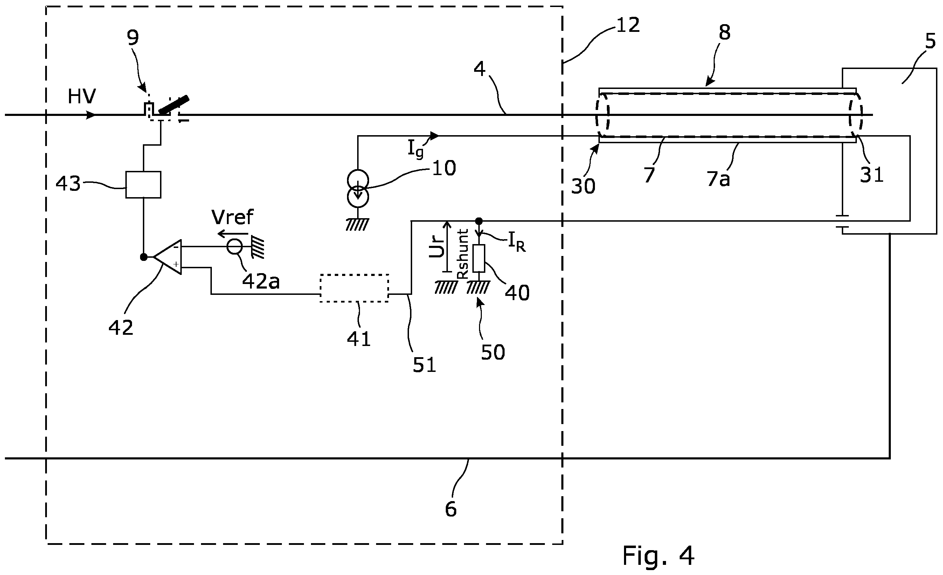

L'aéronef A comprend en outre une structure conductrice (non représentée) qui est formée par tout élément métallique/conducteur de l'aéronef qui est au potentiel de référence et forme la masse 50 (visible sur la figure 4).

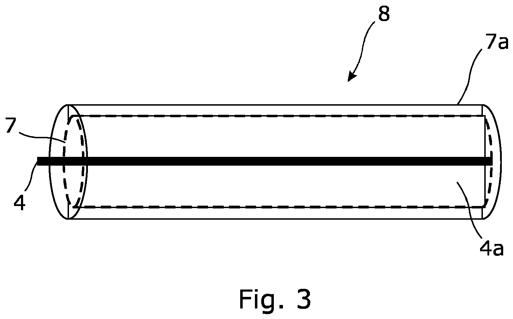

En référence avec les figures 2 à 3, et selon l'invention, la liaison électrique comprend un conducteur 4 entouré d'une enveloppe isolante 4a (par exemple une gaine plastique) et le dispositif de protection électrique 3 comprend une partie arrangée sur l'enveloppe isolante 4a du conducteur électrique 4, et une partie composée de dispositifs électroniques, par exemple arrangés dans un boitier sécurisé 12.

La partie arrangée sur l'enveloppe isolante 4a comprend une gaine conductrice 7 entourée d'une enveloppe isolante 7a, la gaine conductrice 7 entourant l'enveloppe isolante 4a du conducteur 4.

La partie située dans le boitier 12 (voir la figure 2) comprend :
- un coupe-circuit 9 relié à la source d'alimentation en haute tension 2 et qui, lorsqu'il est commandé en ce sens, permet d'interrompre la fourniture du signal HV à l'équipement utilisateur 5. De manière connue, le coupe-circuit 9 fonctionne comme un interrupteur qui lorsque activé, s'ouvre et met ainsi le conducteur 4 hors tension.
- un générateur de courant 10 ; et
- un module de détection 11 pour détecter une fuite de courant hors du conducteur 4.

Une fuite de courant se produit lorsque la liaison électrique est endommagée : par exemple, contact du conducteur 4 avec la gaine conductrice 7 lorsque l'enveloppe isolante 4a est endommagée ou un contact du conducteur 4 avec un élément extérieur à la liaison électrique lorsque les deux enveloppes isolantes 4a et 7a sont endommagées. Une fuite de courant peut entraîner la création d'arc électriques entre le conducteur et la structure conductrice de l'aéronef A ou avec un autre conducteur mis a un potentiel diffèrent du conducteur ou avec la ligne de retour de courant 6 si celle-ci est à un potentiel diffèrent de la masse.

La liaison électrique 8 s'étend avantageusement du boitier 12 jusqu'à l'équipement utilisateur 5 (seule une portion de la liaison électrique a été représentée sur la figure 4).

Le générateur de courant 10 assure la fonction de polarisation en courant de la gaine conductrice 7 en injectant un courant de polarisation Ig continu sur la gaine conductrice 7 à un point d'injection du courant 30 qui est, par exemple, situé au niveau de l'extrémité amont (côté boîtier) de la liaison électrique 8.

Le générateur de courant est de préférence limité en tension avec une limitation en tension choisie pour être non dangereuse pour les personnes physique, typiquement inférieure à 50Volts. Cette option préférentielle permet d'ajouter un degré de protection supplémentaire pour les personnes physiques.

De préférence, le signe du courant de polarisation Ig est inverse de celui de la tension HV délivrée par la source d'alimentation en haute tension 2, afin d'accélérer la détection d'une fuite de courant par le module de détection 11. Par exemple, le courant de polarisation Ig délivré par le génerateir de courant 20 est de -1 A pour une tension HV de 540 Volts DC délivrée par la source d'alimentation en haute tension 2.

Le module de détection 11 (voir figure 4) comprend un shunt 40 utilisé pour mesurer le courant Ir prélevé au point de prélèvement 31 de la gaine conductrice 7, un comparateur 42 connecté au shunt 40, ainsi qu'un microcontrôleur 43 reliant la sortie du comparateur 42 à l'entrée du coupe-circuit 9. Le microcontrôleur reçoit ainsi un signal de sortie du comparateur 42 et fournit un signal de commande au coupe-circuit 9.

Le shunt 40, de résistance Rshunt connue, est connecté à une première borne au point de prélèvement de courant 31 de la gaine conductrice 7 et à une seconde borne à la masse 50 Le point de prélèvement de courant 31 est, par exemple, situé au niveau de l'extrémité aval (côté équipement utilisateur 5) de la liaison électrique 8.

Le comparateur 42 est connecté, sur une première entrée, à la première borne du shunt 40 via une liaison électrique dite ligne de détection 51, et sur une seconde entrée, à un générateur de tension continue 42a fournissant une tension, dite de référence, Vref,

Le comparateur 42 compare la tension Ur dans la ligne de détection 51, qui est proportionnelle à l'intensité Ir mesurée via le shunt 40 (Ur = Ir.Rshunt), à la tension de référence Vref proportionnelle à un courant de référence Iref (Vref vérifie Vref= Rshunt.Iref). Le signal de sortie du comparateur peut prendre deux états, soit un premier état indicatif d'une fuite de courant hors de la liaison électrique 8 soit un second état indicatif d'une absence de fuite de courant hors de la liaison électrique 8.

Dans le cas d'une absence de fuite de courant hors du conducteur 4, Ir = Ig et Ur=Ig.Rshunt < Vref. On parle alors d'une tension Ur dans la ligne de détection 51 qui est nominale.

A titre d'exemple (voir figure 4), si on se place dans une logique Booléenne dans laquelle le premier état du signal de sortie du comparateur 42 correspond à l'état 1 et le second état du signal de sortie correspond à l'état 0, et si la tension HV est positive et le courant de polarisation Ig est négatif, on branche l'entrée négative du comparateur sur le générateur de tension 42a et l'entrée positive sur la ligne de détection 51 de sortie que le signal de sortie du comparateur passe à 1 lorsque Ur devient supérieur à Vref.

Le microcontrôleur 43 est configuré pour surveiller un changement d'état du signal de sortie du comparateur 42, afin de détecter une fuite de courant hors de la liaison électrique 8. Si le microcontrôleur détecte un changement d'état du signal de sortie du second état vers le premier état, il envoie un signal de commande au coupe-circuit 9 comprenant des instructions afin d'activer ledit coupe-circuit pour couper la fourniture en haute tension HV à l'équipement utilisateur 5.

En option, un filtre passe bas (actif, passif ou hybride) 41 est arrangé entre le comparateur 42 et le shunt 40 de sorte à éliminer les signaux d'interférences éventuellement présents sur la gaine conductrice 7 et qui pourrait fausser les résultats des comparaisons effectuées par comparateur 42.

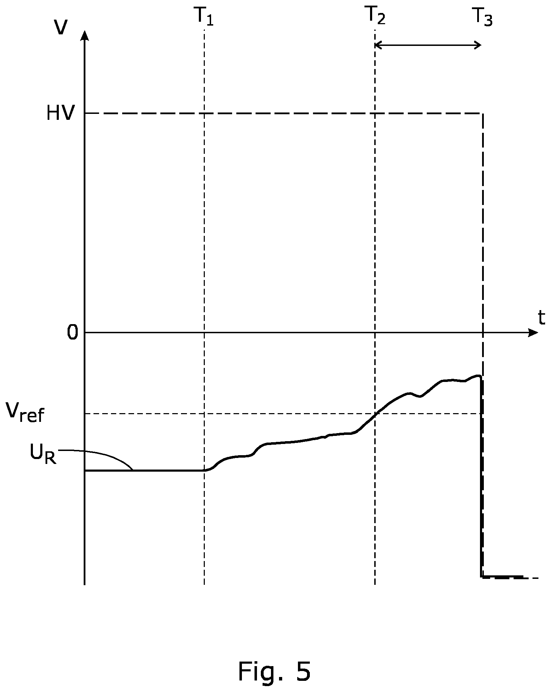

En relation avec la figure 5, il est représenté un exemple d'évolution des signaux HV et Ur au cours du temps, lorsque à partir d'un temps T1, la liaison électrique 8 présente un défaut (cas d'un défaut/rupture de l'enveloppe isolante 4a ou d'un défaut/rupture des enveloppes isolantes 4a et 7a) et qu'une situation de fuite de courant hors du conducteur 4 apparaît.

Dans ces exemples, la source d'alimentation en haute tension 2 produit une tension HV positive, et Ir est négatif, et :
HV=540 V
Ig = -1 A,
Rshunt = 10 Ohms,
Vref = -5V soit un défaut détecté dès que le courant de fuite Ir atteint 0.5A.

Considérant ces données, Ur nominal est égal à -10 V.

D'un temps 0 jusqu'au temps T1, il ne se produit pas de fuite de courant hors de la liaison électrique 8, et la tension Ur dans la ligne de détection 51 est constante et bornée par Vref comme borne supérieure.

Au temps T1, le conducteur 4, par exemple est mis en contact avec la gaine conductrice 7 (défaut de l'enveloppe isolante 4a) et la tension Ur dans la ligne de détection 51 augmente jusqu'à dépasser la tension de référence Vref au temps T2. A partir de ce moment, le signal de sortie du comparateur 41 passe de son second état vers son premier état et le microcontrôleur 43 recevant le signal du comparateur 42 envoie un signal de commande au coupe-circuit comprenant des instructions pour activer le coupe-circuit. Au temps T3, le coupe-circuit 9 est activé et la fourniture en énergie électrique est interrompue : la tension HV devient nulle. La période entre les temps T2 et T3, de l'ordre de quelques millisecondes, correspond au temps de réaction des dispositifs électroniques composants le module de détection 11 ainsi qu'au temps de réaction du coupe-circuit 9.

Un tel dispositif protection électrique 3 selon l'invention permet, dès qu'une fuite de courant est détectée, l'interruption de la fourniture en énergie électrique après un temps de réaction bref des circuits électroniques. La gaine conductrice 7 polarisée en courant forme ainsi un détecteur capable de détecter un endommagement de la liaison électrique 8. La coupure rapide (quelques millisecondes) de l'énergie électrique évite les dommages par effet thermique aux matériaux environnants ainsi que l'injection de courant dans les matériaux environnants, ainsi que la propagation de la haute tension HV dans d'autres câbles/conducteurs.

Les caractéristiques du shunt 40 sont choisies pour que la tension Ur dans la ligne de détection 51, avant T1 sur la figure 5, soit inférieure à la limitation en tension du générateur de courant 10 fournissant Ig. Un contact de la gaine conductrice 7 polarisée (lorsque la liaison électrique 8 ne présente pas de défaut) avec une personne physique est sans danger car la gaine conductrice 7 n'est pas à un potentiel électrique dangereux pour les personnes.

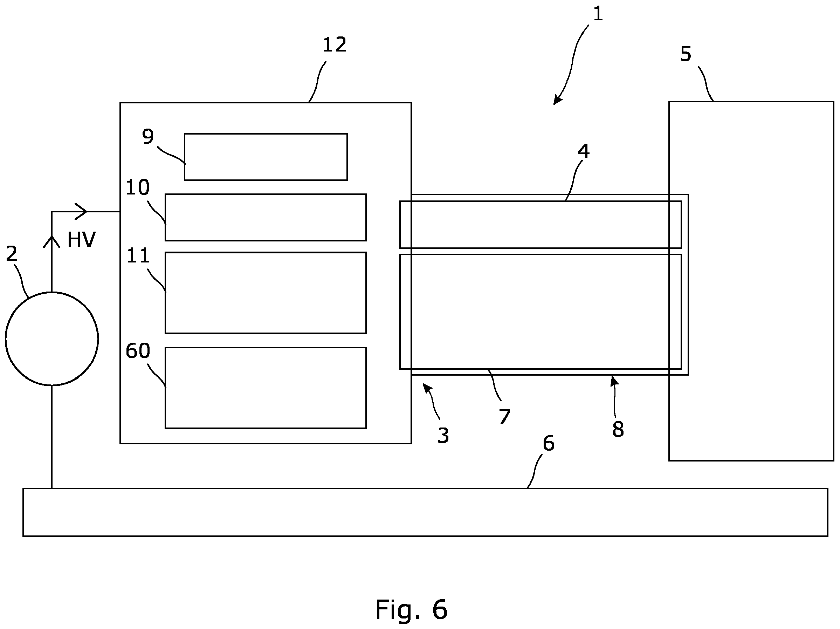

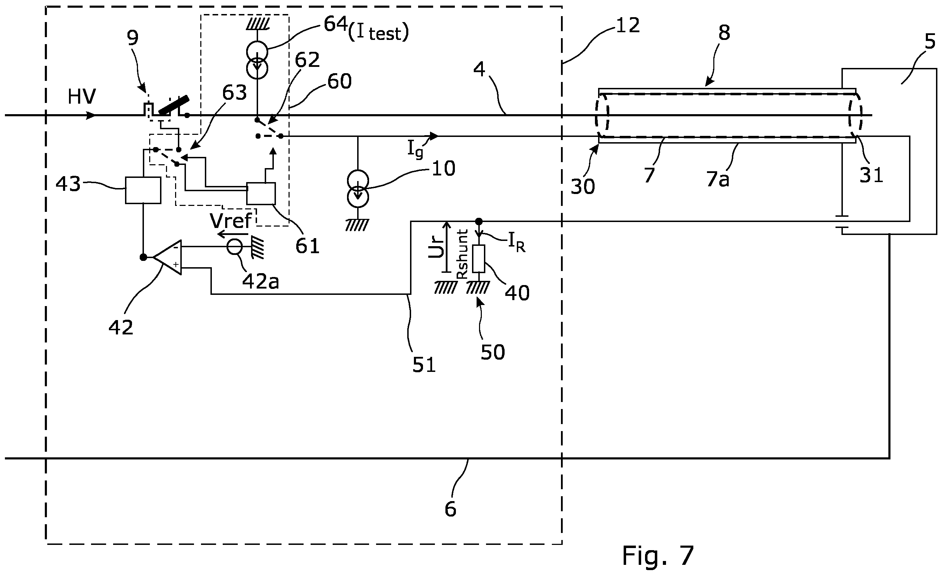

Dans une variante de réalisation de l'invention représentée aux figures 6 et 7, le dispositif de protection électrique 3 comprend en outre un module de test 60 permettant de vérifier le bon fonctionnement du module de détection 11. Le module de test 60 est constitué d'une unité centrale 61 associé à un premier commutateur 62 et à un second commutateur 63. L'unité centrale 61 commande la commutation des commutateurs 62 et 63.

Le premier commutateur 62 est connecté au point d'injection 30 (soit directement soit indirectement. Dans ce dernier cas, il est, par exemple, connecté à la sortie du générateur de courant 10 et peut commuter sur une première borne en l'air ou sur une seconde borne reliée à un générateur de courant 64 fournissant un courant, dit courant de test, Itest de même signe que le courant de polarisation Ig et choisi de sorte que la valeur du courant de test Ir additionnée à la valeur du courant de polarisation Ig entraîne le passage signal de sortie du comparateur 42 vers son premier état.

Par exemple, en reprenant l'exemple donné en relation avec la figure 5, Itest=0.55A.

Le second commutateur 63 est connecté à la sortie du microcontrôleur 43 et peut commuter sur une première borne reliée à l'unité centrale 61 de sorte à ce que seule cette dernière reçoit le signal de commande du microcontrôleur 43 ou sur une seconde borne reliée à l'entrée du coupe-circuit 9 de sorte à ce que ce soit seulement le coupe-circuit qui reçoit le signal de commande du microcontrôleur 43.

Le second commutateur 63 est connecté à la sortie du microcontrôleur 43 du module de détection 11 et peut commuter sur deux différentes bornes :
- une première borne reliée au microcontrôleur 61 du module de test, ou
- une seconde borne reliée à l'entrée du coupe-circuit 9.

L'unité centrale 61 est configurée pour contrôler les commutateurs 62,63 et mettre en œuvre une étape de test à intervalles réguliers et pendant une durée prédéterminée.

Lorsque l'étape de test n'est pas mise en œuvre, l'unité centrale 61 commande la commutation du premier commutateur 62 sur sa première borne et la commutation du second commutateur 63 sur sa seconde borne.

Lorsque l'unité centrale 61 met en œuvre l'étape de test :
- le premier commutateur 62 commute sur sa seconde borne de sorte à forcer l'entrée du module de détection 11 (on force le courant injecté dans la gaine à dépasser la valeur de référence haute Iref1) et le second commutateur 63 commute sur sa première borne de sorte à ne pas activer le coupe-circuit 9 pendant la mise en œuvre du test ; et
- l'unité centrale 61 reçoit le signal de commande du microcontrôleur 43 et surveille un changement d'état dudit signal du second état au premier état, et peut ainsi vérifier si le module de détection 11 est opérant, c'est-à-dire qu'il a bien généré un signal contenant des instructions d'activation du coupe-circuit 9. Si à l'issu d'un temps de test prédéterminé, le module de détection 11 n'a pas le signal pour activer le coupe-circuit, l'unité centrale 61 émet une alerte à destination d'un opérateur qui peut suivant son choix maintenir la fourniture énergie électrique jusqu'à la fin du vol de l'aéronef par exemple, soit provoquer l'interruption de la fourniture en énergie électrique en actionnant par exemple un coupe circuit manuel (non représenté) dans le cockpit de l'aéronef. Un opérateur devra réparer le module de détection 11 pour que le système de sécurisation de la fourniture en énergie électrique redevienne opérationnel.

Dans la description ci-dessus, par ligne de retour de courant 6, on entend soit un conducteur de retour, ou soit un réseau de retour de courant. Si la ligne de retour de courant 6 est un conducteur mis à une tension différente de celle de la structure conductrice de l'aéronef, alors un dispositif de protection électrique tel que décrit plus haut devra être associé à la ligne de retour de courant 6 pour sécuriser le retour de courant.

Dans une variante non représentée, afin que la gaine conductrice 7 et son enveloppe isolante 7a forment un blindage électrique (qui joue également le rôle de blindage contre la foudre ou des impulsions électromagnétiques) du conducteur électrique 4 et de son enveloppe isolante 4a, un premier élément écrêteur est arrangé entre le générateur de courant 10 et le point d'injection 30 et un second élément écrêteur est arrangé entre le point de prélèvement 31 et le shunt 400. Les deux éléments écrêteurs sont des diodes de suppression de tensions transitoires (transient-voltage-suppression diode en anglais) avec une tension de claquage supérieure à Vref en valeur absolue.

L'invention a été décrite pour protéger la transmission d'énergie électrique via une liaison électrique d'une installation électrique 1 d'un aéronef A. Cependant, l'invention trouve application à tout autre type de véhicule, par exemple un navire ou une automobile.

L'invention a été décrite, notamment via l'exemple illustré à la figure 5, pour une tension HV positive et un courant de polarisation négatif. La modification de l'invention pour prendre en compte d'autres paramètres (tension HV positive, courant de polarisation positif ou négatif) est à la portée de l'homme du métier.

## Revendications

1. Liaison électrique (8) adaptée à relier une source d'énergie haute tension à courant continu (2) à un équipement utilisateur (5), la liaison électrique comprenant un conducteur électrique (4) entouré d'une enveloppe isolante (4a), la liaison électrique (8) comprenant un dispositif de protection (3) électrique comprenant :
- une gaine conductrice (7) arrangé autour de l'enveloppe isolante (4a),
- un coupe-circuit (9) arrangé sur le conducteur et configuré pour couper un courant transitant via le conducteur (4), et
- un module de détection (11) connecté à un point de prélèvement de courant (31) de la gaine conductrice (7) et au coupe-circuit (9) et configuré pour détecter une fuite de courant hors du conducteur (4) et commander le coupe-circuit (9),
**caractérisé en ce que** la liaison électrique comprend en outre un générateur de courant (10) connecté à un point d'injection de courant (30) de la gaine conductrice (7), le générateur de courant (10) étant configuré pour délivrer un courant continu (Ig).

2. Liaison (8) selon la revendication 1, **caractérisé en ce que** le module de détection (11) comprend :
- un shunt (40) connecté, en utilisation, au point de prélèvement (31) à une première borne du shunt et à une masse (50) à la seconde borne du shunt ;
- un comparateur (42) dont une première entrée est connectée à la première borne du shunt (40) via une liaison électrique, dite ligne de détection (51), et dont une seconde entrée est connectée à un générateur de tension continue (42a) fournissant une tension dite de référence (Vref) ; et
- un microcontrôleur (43) connecté entre une sortie du comparateur (42) et le coupe-circuit (9), le microcontrôleur étant configuré pour envoyer un signal de commande au coupe-circuit en fonction d'un signal de sortie reçu du comparateur (42).

3. Liaison (8) selon la revendication 2, **caractérisé en ce qu'**elle comprend un module de test (60) du module de détection (11), le module de test comprenant une unité centrale (61) associé à un premier commutateur (62) et à un second commutateur (63), l'unité centrale (61) étant configuré pour commander la commutation des commutateurs ;
• le premier commutateur (62) étant connecté au point d'injection (30) et pouvant commuter sur une première borne en l'air ou sur une seconde borne reliée à un générateur de courant (64) fournissant un courant continu (Itest), dit courant de test ; et
• le second commutateur (63) étant connecté à la sortie du microcontrôleur (43) et pouvant commuter sur une première borne reliée à l'unité centrale de sorte à ce que seule ladite unité reçoit le signal de commande du microcontrôleur (43) ou sur une seconde borne reliée au coupe-circuit (9) de sorte à ce que ce soit le coupe-circuit seulement qui reçoit le signal de commande du microcontrôleur (43).

4. Liaison (8) selon l'une quelconque des revendications 2 à 3, **caractérisé en ce que** le module de détection (11) comprend un filtre passe-bas (41) arrangé sur la ligne de détection (51).

5. Liaison (8) selon l'une quelconque des revendications 2 à 4, **caractérisé en ce qu'**une enveloppe isolante (7a) entoure la gaine conductrice (7).

6. Procédé de fourniture sécurisée d'énergie électrique à un équipement utilisateur (5) d'un véhicule (A) via une liaison électrique (8) connectée entre l'équipement utilisateur (5) et une source d'alimentation (2) fournissant une tension continue (HV), le véhicule (A) comportant une structure conductrice formant masse (50), la liaison électrique (8) comprenant:
- un conducteur électrique (4) entouré d'une enveloppe isolante (4a) ;
- un dispositif de protection (3) électrique comprenant :
∘ une gaine conductrice (7) arrangé autour de l'enveloppe isolante (4a) ;
∘ un générateur de courant (10) connecté à un point d'injection de courant (30) de la gaine conductrice (7) ;
∘ un coupe-circuit (9) arrangé sur le conducteur et configuré pour couper un courant transitant via le conducteur (4) ; et
∘ un module de détection (11) comprenant un shunt (40) ayant une première borne connectée à un point de prélèvement de courant (31) de la gaine conductrice (7) et une seconde borne connecté à la masse (50), un comparateur (42) dont une première entrée est connectée à la première borne du shunt (40) via une liaison électrique, dite ligne de détection (51), et dont une seconde entrée est connectée à un générateur de tension continue (42a) fournissant une tension dite de référence (Vref) ; et un microcontrôleur (43) connecté entre une sortie du comparateur (42) et le coupe-circuit (9),
**caractérisé en ce que** le procédé comprend les étapes successives suivantes :
- injection, par le générateur de courant (10), d'un courant continu (Ig) au point d'injection de courant (30) ;
- mesure de l'intensité d'un courant (Ig), via le shunt (50), prélevé au point de prélèvement de courant (31) ;
- comparaison, par le comparateur (42), d'une tension (Ur) sur la ligne de détection (51) avec la tension de référence (Vref), la tension (Ur) sur la ligne de détection étant proportionnelle à l'intensité du courant (Ig) mesuré via le shunt ;
- surveillance, par le microcontrôleur (43), de l'état du signal de sortie du comparateur (42), ledit état étant soit un premier état indicatif d'une fuite de courant hors du conducteur (4) soit un second état sinon ; et
- activation du coupe-circuit (9), par le microcontrôleur (43), si le signal de sortie du comparateur est dans le premier état.

7. Procédé selon la revendication 6, **caractérisé en ce que** le générateur de courant (10) injecte un courant (Ig) de signe opposé au signe de la tension (HV) fournie par la source d'alimentation (2).

8. Procédé selon la revendication 6, le module de détection (11) comprenant en outre un module de test (60) comprenant une unité centrale (61) associé à un premier commutateur (62) et à un second commutateur (63), l'unité centrale (61) commandant la commutation des commutateurs ;
• le premier commutateur (62) étant connecté au point d'injection de courant (30) et pouvant commuter sur une première borne en l'air ou sur une seconde borne reliée à un générateur de courant (64) fournissant un courant continu (Itest), dit courant de test, choisi de sorte que la valeur du courant de test (Itest) additionnée à la valeur du courant de polarisation (Ig) entraîne le passage du signal de sortie du comparateur (42) vers son premier état ;
• le second commutateur (63) étant connecté à la sortie du microcontrôleur (43) et pouvant commuter sur une première borne reliée à l'unité centrale de sorte que seule ladite unité reçoit le signal de commande du microcontrôleur (43) ou sur une seconde borne reliée au coupe-circuit (9) de sorte à ce que ce soit le coupe-circuit (9) seulement qui reçoit le signal de commande du microcontrôleur (43) ;
**caractérisé en ce que** le procédé comprend une étape de test, mise en œuvre durant un temps prédéterminé, durant laquelle l'unité centrale (61) commande le premier commutateur (62) pour le faire commuter sur sa seconde borne et commande le second commutateur (63) pour le faire commuter sur sa première borne, et dans laquelle l'unité centrale (61) surveille un changement d'état du signal de commande du microcontrôleur (43) ;
lorsque l'étape de test n'est pas mise en œuvre, l'unité centrale (61) commande le premier commutateur (62) pour le faire commuter sur sa première borne et commande le second commutateur (63) pour le faire commuter sur sa seconde borne.

## Patentansprüche

1. Elektrischer Anschluss (8), der dazu angepasst ist, eine Gleichstrom-Hochspannungsenergiequelle (2) an eine Benutzerausrüstung (5) anzuschließen, wobei der elektrische Anschluss einen elektrischen Leiter (4) beinhaltet, der von einem isolierenden Mantel (4a) umgeben ist, wobei der elektrische Anschluss (8) eine elektrische Schutzvorrichtung (3) beinhaltet, die Folgendes beinhaltet:
- eine leitende Hülle (7), die um den isolierenden Mantel (4a) angeordnet ist,
- einen Unterbrecher (9), der in dem Leiter angeordnet ist und dazu konfiguriert ist, einen durch den Leiter (4) hindurchgehenden Strom zu unterbrechen, und
- ein Detektionsmodul (11), das mit einem Stromentnahmepunkt (31) der leitenden Hülle (7) und mit dem Unterbrecher (9) verbunden ist und dazu konfiguriert ist, einen Leckstrom außerhalb des Leiters (4) zu detektieren und den Unterbrecher (9) zu steuern,
**dadurch gekennzeichnet, dass** der elektrische Anschluss ferner einen Stromgenerator (10) beinhaltet, der mit einem Stromeinspeisepunkt (30) der leitenden Hülle (7) verbunden ist, wobei der Stromgenerator (10) dazu konfiguriert ist, einen Gleichstrom (Ig) zu liefern.

2. Anschluss (8) nach Anspruch 1, **dadurch gekennzeichnet, dass** das Detektionsmodul (11) Folgendes beinhaltet:
- einen Shunt (40), der im Gebrauch an einer ersten Klemme des Shunts mit dem Entnahmepunkt (31) und an der zweiten Klemme des Shunts mit einer Masse (50) verbunden ist;
- einen Komparator (42), von dem ein erster Eingang mit der ersten Klemme des Shunts (40) über einen elektrischen Anschluss, der als Detektionsleitung (51) bezeichnet wird, verbunden ist und von dem ein zweiter Eingang mit einem Gleichspannungsgenerator (42a), der eine sogenannte Referenzspannung (Vref) bereitstellt, verbunden ist; und
- einen Mikrocontroller (43), der zwischen einem Ausgang des Komparators (42) und dem Unterbrecher (9) verbunden ist, wobei der Mikrocontroller dazu konfiguriert ist, in Abhängigkeit von einem von dem Komparator (42) empfangenen Ausgangssignal ein Steuersignal an den Unterbrecher zu senden.

3. Anschluss (8) nach Anspruch 2, **dadurch gekennzeichnet, dass** er ein Testmodul (60) für das Detektionsmodul (11) beinhaltet, wobei das Testmodul eine Zentraleinheit (61) beinhaltet, die mit einem ersten Schalter (62) und mit einem zweiten Schalter (63) assoziiert ist, wobei die Zentraleinheit (61) dazu konfiguriert ist, das Umschalten der Schalter zu steuern;
• wobei der erste Schalter (62) mit dem Einspeisepunkt (30) verbunden ist und zu einer ersten freien Klemme oder zu einer zweiten, an einen Stromgenerator (64) angeschlossenen Klemme umschalten kann, welcher einen Gleichstrom (Itest), der als Teststrom bezeichnet wird, bereitstellt; und
• wobei der zweite Schalter (63) mit dem Ausgang des Mikrocontrollers (43) verbunden ist und zu einer ersten, an die Zentraleinheit angeschlossenen Klemme umschalten kann, sodass nur die Einheit das Steuersignal des Mikrocontrollers (43) empfängt, oder zu einer zweiten, an den Unterbrecher (9) angeschlossenen Klemme umschalten kann, sodass es nur der Unterbrecher ist, der das Steuersignal des Mikrocontrollers (43) empfängt;

4. Anschluss (8) nach einem der Ansprüche 2 bis 3, **dadurch gekennzeichnet, dass** das Detektionsmodul (11) ein Tiefpassfilter (41) beinhaltet, das in der Detektionsleitung (51) angeordnet ist.

5. Anschluss (8) nach einem der Ansprüche 2 bis 4, **dadurch gekennzeichnet, dass** ein isolierender Mantel (7a) die leitende Hülle (7) umgibt.

6. Verfahren zur sicheren Bereitstellung von elektrischer Energie für eine Benutzerausrüstung (5) eines Fahrzeugs (A) über einen elektrischen Anschluss (8), der zwischen der Benutzerausrüstung (5) und einer Versorgungsquelle (2), die eine Gleichspannung (HV) bereitstellt, verbunden ist, wobei das Fahrzeug (A) eine leitende Struktur umfasst, die die Masse (50) bildet, wobei der elektrische Anschluss (8) Folgendes beinhaltet:
- einen elektrischen Leiter (4), der von einem isolierenden Mantel (4a) umgeben ist;
- eine elektrische Schutzvorrichtung (3), die Folgendes beinhaltet:
∘ eine leitende Hülle (7), die um den isolierenden Mantel (4a) angeordnet ist;
∘ einen Stromgenerator (10), der mit einem Stromeinspeisepunkt (30) der leitenden Hülle (7) verbunden ist;
∘ einen Unterbrecher (9), der in dem Leiter angeordnet ist und dazu konfiguriert ist, einen durch den Leiter (4) hindurchgehenden Strom zu unterbrechen; und
∘ ein Detektionsmodul (11), das einen Shunt (40), der eine erste Klemme, die mit einem Stromentnahmepunkt (31) der leitenden Hülle (7) verbunden ist, und eine zweite Klemme, die mit der Masse (50) verbunden ist, aufweist, einen Komparator (42), von dem ein erster Eingang mit der ersten Klemme des Shunts (40) über einen elektrischen Anschluss, der als Detektionsleitung (51) bezeichnet wird, verbunden ist und von dem ein zweiter Eingang mit einem Gleichspannungsgenerator (42a), der eine sogenannte Referenzspannung (Vref) bereitstellt, verbunden ist; und einen Mikrocontroller (43), der zwischen einem Ausgang des Komparators (42) und dem Unterbrecher (9) verbunden ist, beinhaltet,
**dadurch gekennzeichnet, dass** das Verfahren die folgenden aufeinanderfolgenden Schritte beinhaltet:
- Einspeisen, durch den Stromgenerator (10), eines Gleichstroms (Ig) an dem Stromeinspeisepunkt (30);
- Messen, über den Shunt (50), der Stärke eines Stroms (Ig), der an dem Stromentnahmepunkt (31) entnommen wird;
- Vergleichen, durch den Komparator (42), einer Spannung (Ur) an der Detektionsleitung (51) mit der Referenzspannung (Vref), wobei die Spannung (Ur) an der Detektionsleitung zu der über den Shunt gemessenen Stromstärke (Ig) proportional ist;
- Überwachen, durch den Mikrocontroller (43), des Zustands des Ausgangssignals des Komparators (42), wobei der Zustand entweder ein erster Zustand, der einen Leckstrom außerhalb des Leiters (4) anzeigt, oder andernfalls ein zweiter Zustand ist; und
- Aktivieren des Unterbrechers (9), durch den Mikrocontroller (43), wenn das Ausgangssignal des Komparators in dem ersten Zustand ist.

7. Verfahren nach Anspruch 6, **dadurch gekennzeichnet, dass** der Stromgenerator (10) einen Strom (Ig) mit einem Vorzeichen, das zu dem Vorzeichen der durch die Versorgungsquelle (2) bereitgestellten Spannung (HV) entgegengesetzt ist, einspeist.

8. Verfahren nach Anspruch 6, wobei das Detektionsmodul (11) ferner ein Testmodul (60) beinhaltet, das eine Zentraleinheit (61) beinhaltet, die mit einem ersten Schalter (62) und mit einem zweiten Schalter (63) assoziiert ist, wobei die Zentraleinheit (61) das Umschalten der Schalter steuert;
• wobei der erste Schalter (62) mit dem Stromeinspeisepunkt (30) verbunden ist und zu einer ersten freien Klemme oder zu einer zweiten, an einen Stromgenerator (64) angeschlossenen Klemme umschalten kann, welcher einen Gleichstrom (Itest), der als Teststrom bezeichnet wird, bereitstellt, der so ausgewählt ist, dass der Wert des Teststroms (Itest), wenn er zu dem Vorspannungsstromwert (Ig) addiert wird, das Übergehen des Ausgangssignals des Komparators (42) in seinen ersten Zustand bewirkt;
• wobei der zweite Schalter (63) mit dem Ausgang des Mikrocontrollers (43) verbunden ist und zu einer ersten, an die Zentraleinheit angeschlossenen Klemme umschalten kann, sodass nur die Einheit das Steuersignal des Mikrocontrollers (43) empfängt, oder zu einer zweiten, an den Unterbrecher (9) angeschlossenen Klemme umschalten kann, sodass es nur der Unterbrecher (9) ist, der das Steuersignal des Mikrocontrollers (43) empfängt;
**dadurch gekennzeichnet, dass** das Verfahren einen Schritt des Testens beinhaltet, der während eines vorgegebenen Zeitraums ausgeführt wird, während dessen die Zentraleinheit (61) den ersten Schalter (62) so steuert, dass dieser auf seine zweite Klemme umschaltet, und den zweiten Schalter (63) so steuert, dass dieser auf seine erste Klemme umschaltet, und wobei die Zentraleinheit (61) eine Zustandsänderung des Steuersignals des Mikrocontrollers (43) überwacht;
wobei, wenn der Test nicht ausgeführt wird, die Zentraleinheit (61) den ersten Schalter (62) so steuert, dass dieser auf seine erste Klemme umschaltet, und den zweiten Schalter (63) so steuert, dass dieser auf seine zweite Klemme umschaltet.

## Claims

1. Electrical connection (8) suitable for connecting a high-voltage DC power source (2) to a user apparatus (5), the electrical connection comprising an electrical conductor (4) surrounded by an insulating envelope (4a), the electrical connection (8) comprising an electrical protection device (3) comprising:
- a conductive sheath (7) arranged around the insulating envelope (4a),
- a circuit breaker (9) arranged on the conductor and configured to break a current passing through the conductor (4), and
- a detection module (11) connected to a current tap-off point (31) of the conductive sheath (7) and to the circuit breaker (9) and configured to detect a leakage of current out of the conductor (4) and to control the circuit breaker (9),
**characterized in that** the electrical connection further comprises a current generator (10) connected to a current-injection point (30) of the conductive sheath (7), the current generator (10) being configured to deliver a DC current (Ig).

2. Connection (8) according to Claim 1, **characterized in that** the detection module (11) comprises:
- a shunt (40) connected, in use, to the tap-off point (31) at a first terminal of the shunt and to ground (50) at the second terminal of the shunt;
- a comparator (42) a first input of which is connected to the first terminal of the shunt (40) via an electrical connection, called detection line (51), and a second input of which is connected to a DC voltage generator (42a) supplying a voltage called reference voltage (Vref); and
- a microcontroller (43) connected between an output of the comparator (42) and the circuit breaker (9), the microcontroller being configured to send a control signal to the circuit breaker according to an output signal received from the comparator (42).

3. Connection (8) according to Claim 2, **characterized in that** it comprises a test module (60) for the detection module (11), the test module comprising a central unit (61) associated with a first switch (62) and with a second switch (63), the central unit (61) being configured to control the switching of the switches;
• the first switch (62) being connected to the injection point (30) and being able to switch to a first non-connected terminal or to a second terminal connected to a current generator (64) supplying a DC current (Itest), called test current; and
• the second switch (63) being connected to the output of the microcontroller (43) and being able to switch to a first terminal connected to the central unit such that only said unit receives the control signal from the microcontroller (43) or to a second terminal connected to the circuit breaker (9) such that it is only the circuit breaker which receives the control signal from the microcontroller (43).

4. Connection (8) according to either one of Claims 2 and 3, **characterized in that** the detection module (11) comprises a low-pass filter (41) arranged on the detection line (51).

5. Connection (8) according to any one of Claims 2 to 4, **characterized in that** an insulating envelope (7a) surrounds the conductive sheath (7).

6. Method for securely supplying electrical power to a user apparatus (5) of a vehicle (A) via an electrical connection (8) connected between the user apparatus (5) and a power source (2) supplying a DC voltage (HV), the vehicle (A) including a ground-forming conductive structure (50), the electrical connection (8) comprising:
- an electrical conductor (4) surrounded by an insulating envelope (4a);
- an electrical protection device (3) comprising:
∘ a conductive sheath (7) arranged around the insulating envelope (4a);
∘ a current generator (10) connected to a current-injection point (30) of the conductive sheath (7);
∘ a circuit breaker (9) arranged on the conductor and configured to break a current passing through the conductor (4); and
∘ a detection module (11) comprising a shunt (40) having a first terminal connected to a current tap-off point (31) of the conductive sheath (7) and a second terminal connected to ground (50), a comparator (42) a first input of which is connected to the first terminal of the shunt (40) via an electrical connection, called detection line (51), and a second input of which is connected to a DC voltage generator (42a) supplying a voltage called reference voltage (Vref); and a microcontroller (43) connected between an output of the comparator (42) and the circuit breaker (9),
**characterized in that** the method comprises the following successive steps:
- injection, by the current generator (10), of a DC current (Ig) at the current-injection point (30);
- measurement of the intensity of a current (Ig), via the shunt (50), tapped off at the current tap-off point (31);
- comparison, by the comparator (42), of a voltage (Ur) on the detection line (51) with the reference voltage (Vref), the voltage (Ur) on the detection line being proportional to the intensity of the current (Ig) measured via the shunt;
- monitoring, by the microcontroller (43), of the state of the output signal of the comparator (42), said state being either a first state indicative of a leakage of current out of the conductor (4) or otherwise a second state; and
- activation of the circuit breaker (9), by the microcontroller (43), if the output signal of the comparator is in the first state.

7. Method according to Claim 6, **characterized in that** the current generator (10) injects a current (Ig) of opposite sign to the sign of the voltage (HV) supplied by the power source (2).

8. Method according to Claim 6, the detection module (11) further comprising a test module (60) comprising a central unit (61) associated with a first switch (62) and with a second switch (63), the central unit (61) controlling the switching of the switches;
• the first switch (62) being connected to the current-injection point (30) and being able to switch to a first non-connected terminal or to a second terminal connected to a current generator (64) supplying a DC current (Itest), called test current, chosen such that the value of the test current (Itest) added to the value of the bias current (Ig) brings about the transition of the output signal of the comparator (42) to its first state;
• the second switch (63) being connected to the output of the microcontroller (43) and being able to switch to a first terminal connected to the central unit such that only said unit receives the control signal from the microcontroller (43) or to a second terminal connected to the circuit breaker (9) such that it is only the circuit breaker (9) which receives the control signal from the microcontroller (43);
**characterized in that** the method comprises a test step, implemented for a predefined time, during which test step the central unit (61) controls the first switch (62) so as to make it switch to its second terminal and controls the second switch (63) so as to make it switch to its first terminal, and in which test step the central unit (61) monitors a change of state of the control signal from the microcontroller (43);
when the test step is not implemented, the central unit (61) controls the first switch (62) so as to make it switch to its first terminal and controls the second switch (63) so as to make it switch to its second terminal.
